(19) Europäisches Patentamt
European Patent Office
Office européen des brevets

(11) **EP 2 883 067 B1**

(12) **EUROPEAN PATENT SPECIFICATION**

(45) Date of publication and mention of the grant of the patent:
**16.01.2019 Bulletin 2019/03**

(21) Application number: **13756337.5**

(22) Date of filing: **08.08.2013**

(51) Int Cl.:
**G01R 31/317** *(2006.01)*     **G01R 29/26** *(2006.01)*

(86) International application number:
**PCT/EP2013/066668**

(87) International publication number:
**WO 2014/023811 (13.02.2014 Gazette 2014/07)**

(54) **EFFICIENT POWER SUPPLY NOISE MEASUREMENT BASED ON TIMING UNCERTAINTY**

EFFIZIENTE STROMVERSORGUNGS-RAUSCHMESSUNG AUF BASIS VON TIMING-UNSICHERHEITEN

MESURE DE BRUIT D'UNE ALIMENTATION ÉLECTRIQUE EFFICACE SUR LA BASE DE L'INCERTITUDE DE LA SYNCHRONISATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **08.08.2012 EP 12305986**
**15.10.2012 US 201261714162 P**

(43) Date of publication of application:
**17.06.2015 Bulletin 2015/25**

(73) Proprietor: **OCT Circuit Technologies International Limited**
**Dublin 18 (IE)**

(72) Inventors:
• **VALKA, Miroslav**
  **F-38200 La Verpilliere (FR)**
• **BOSIO, Alberto**
  **F-34090 Montpellier (FR)**
• **BROUTIN, Mickael**
  **F-38170 Seyssinet Pariset (FR)**
• **DEBAUD, Philippe**
  **F-38410 St Martin D'uriage (FR)**
• **GIRARD, Patrick**
  **F-34400 Villetelle (FR)**
• **GUILHOT, Stéphane**
  **F-38320 Herbeys (FR)**

(74) Representative: **Grünecker Patent- und Rechtsanwälte**
**PartG mbB**
**Leopoldstraße 4**
**80802 München (DE)**

(56) References cited:
**US-A1- 2012 146 665**

• **S. SUNTER ET AL: "On-chip digital jitter measurement, from megahertz to gigahertz", IEEE DESIGN & TEST OF COMPUTERS, vol. 21, no. 4, 1 July 2004 (2004-07-01), pages 314-321, XP055085079, ISSN: 0740-7475, DOI: 10.1109/MDT.2004.38**
• **JUI-JER HUANG ET AL: "Low-cost jitter measurement technique for BIST applications", TEST SYMPOSIUM, 2003. ATS 2003. 12TH ASIAN 16-19 NOV. 2003, PISCATAWAY, NJ, USA,IEEE, 16 November 2003 (2003-11-16), pages 336-339, XP010672509, DOI: 10.1109/ATS.2003.1250833 ISBN: 978-0-7695-1951-7 cited in the application**
• **FRANCH R ET AL: "On-chip timing uncertainty measurements on IBM microprocessors", INTERNATIONAL TEST CONFERENCE 2007, 23-25 OCT.2007, SANTA CLARA, CA, USA, IEEE, PISCATAWAY, NJ, USA, 1 October 2007 (2007-10-01), pages 1-7, XP031206942, DOI: 10.1109/TEST.2007.4437560 ISBN: 978-1-4244-1127-6 cited in the application**

## Description

## BACKGROUND

### Technical Field

The present application generally relates to power supply noise sensors and methods of measuring power supply noise. More particularly, the application relates to sensors that sense power supply noise based on the measurement of a timing uncertainty in a signal within a circuit. The sensors find particular use in integrated circuits, for instance in a System-on-Chip (SoC) architecture for mobile applications.
Such integrated circuits find applications in, for example, mobile devices such as mobile (cell) phones, smart phones, tablets, laptops, and so forth.

### Related Art

The approaches described in this section could be pursued, but are not necessarily approaches that have been previously conceived or pursued. Therefore, unless otherwise indicated herein, the approaches described in this section are not prior art to the claims in this application and are not admitted to be prior art by inclusion in this section.
For a high performance mobile device, such as a smart phone, the integrated circuits for use in such devices must combine a high processing speed with low power consumption. This is to enable the mobile device to achieve the required functionality whilst retaining an acceptable battery lifetime.
Integrated circuits for such applications are usually tested for performance during manufacture to ensure their suitability for use in the device. Timing or delay faults can be detected by using, for example, at-speed scan testing for logic circuits. At-speed scan testing consists of using a particular system clock period between launch and capture for each delay test pattern, typically chosen to be the nominally-rated clock speed of the circuit under test. Conversely, a longer clock period is normally used for scan shifting (load and unload cycles).
Although at-speed scan testing can be used for high-quality delay fault testing, the use of such testing can result in an appreciable test-induced yield loss. A test-induced yield loss occurs when a 'good' chip is declared as being faulty during at-speed scan testing. Documents T Saxena, K. et al, "A Case Study of IR-Drop in Structured At-Speed Testing", IEEE Int'l Test Conf., pp. 1098-1104, 2003, and K. Arabi, et al, "Power Supply Noise in SoCs: Metrics, Management, and Measurement," IEEE Design & Test of Computers, vol. 24, no. 3, May-June 2007 both relate to this problem.
A major cause of test-induced yield loss is Power Supply Noise (PSN). This noise is often caused by IR-drop and Ldi/dt drop within the integrated circuit under test. IR-drop is caused by the resistance of interconnects within the integrated circuit, while Ldi/dt drop is caused by high switching activity in the circuit. This high switching activity in turn leads to a high power consumption within the circuit and thus a drop in the effective supply voltage during switching activity.
In order to deal with this problem, techniques to reduce the risk of artificial yield loss induced by excessive PSN during at-speed scan testing are disclosed in documents Chakravarty S., et al, "Optimal Manufacturing Flow to Determine Minimum Operating Voltage", ITC 2011, pp. 1-10, and Franch R., et al, "On-chip Timing Uncertainty Measurements on IBM Microprocessors", ITC 2007, pp. 1-7. These techniques are mainly based on test pattern modification or power-aware Design-for-Testability (DfT).
As an alternative to these techniques, a system of power supply monitoring can be used. In the process of Franch R., et al, "On-chip Timing Uncertainty Measurements on IBM Microprocessors", ITC 2007, pp. 1-7, a process monitoring box (PMB) is used to determine the actual power consumption. The PMB takes the form of a ring oscillator, whose output is used as the clock of a counter. The counter works during a fixed time window and the output count value, C, is read. The value of C depends on the ring oscillator frequency, and this in turn depends on the physical properties of the integrated circuit and the actual power supply voltage. Thus, C is a measure of the actual frequency. The value of C is then compared with the expected value to verify the system performance. For example, in the presence of PSN the value of C will be lower than the expected value. PMB is easy to implement, however, the value of C is not generally an accurate measure of the actual frequency since it does not depended directly on the applied timuli.
A further method is disclose in Huang JJ., et al, "A Low-Cost Jitter Measurements Technique for BIST Applications", ATS 2003, pp. 336-339. In this document, an embedded sensor is used to measure the timing uncertainty (jitter). The disclosed sensor is composed of delay elements (inverters) and capture elements (latches). The sensor is connected to a clock tree in order to detect clock-timing variations. The sensor can also be reused as a power supply noise monitor. As with the previous technique, this solution suffers from a low degree of precision with respect to the measurement of the power supply noise.
The embodiments described herewith are aimed at providing a system and method of measuring PSN that overcome or mitigate at least some of the problems noted in respect of the above described methods.
S. Sunter et al: "On-chip digital jitter measurement, from megahertz to gighertz", IEEE Design & Test of Computers, vol. 21, no. 4, 1 July 2004, pages 314-321, ISSN: 0740-7475 discloses a method for providing on-chip power supply noise measurement.

## SUMMARY

The invention is defined by the subject matter of the independent claims. In a first aspect, there is provided a power supply noise measurement device for inclusion with an integrated circuit, the integrated circuit having a functional block, the noise measurement device comprising: a signal generator configured to provide a clock signal to the functional block, an antenna comprising a transistor, and being located proximate to the functional block, the antenna being configured to receive the clock signal from the signal generator, and a jitter estimator configured to provide a measure of the relative jitter between a signal output from the antenna and a reference clock signal, wherein the transistor of the antenna receives electrical power from the same power source that delivers power to the functional block.

Thus, an accurate estimate of the power supply noise in a functional block can be made by using a direct measure of the noise in the power supply voltage.

In some embodiments, the antenna comprises a buffer, the buffer comprising a plurality of transistors configured to relay the clock signal from an input of the buffer to an output of the buffer. Thus, the antenna can be formed easily from well known components.

In some embodiments the antenna comprises a plurality of buffers electrically connected in a daisy-chain fashion, whereby the output of buffers in the daisy-chain are connected to the input of the subsequent buffer in the daisy-chain. Thus, an antenna of arbitrary length can be created by connecting together a plurality of buffers.

In some embodiments, the power to the, or each, transistor in the antenna is taken from a mesh of electrical contacts that also provides electrical power to components within the functional block. By receiving electrical power in this manner, it can be ensured that the elements of the antenna directly measure the power supply noise that is experienced by components within the integrated circuit, thereby providing an accurate result.

In some embodiments, the functional block, antenna and jitter estimator are all located within a voltage domain, and wherein a common power source supplies power to the voltage domain. Thus, by employing a system of voltage domains many of the components of the noise measurement device can be powered by the same power source. As a result, these components can be powered down when the functional block under test is also powered down.

In some embodiments, the antenna is formed as a part of the functional block. Thus, the antenna can be located within the circuit under test to enable the most accurate measurement of the power supply noise.

In some embodiments a multiplexer is included, wherein the multiplexer is configured to selectably transfer either the clock signal from the signal generator, or the signal output from the antenna, to the jitter estimator. Thus, the device can permit calibration of the signal from the antenna by comparison with the signal from the signal generator.

In some embodiments a plurality of antennas are provided in or proximate to the functional block, each of the antennas being configured to receive the clock signal from the signal generator, and each being configured to provide an input to the jitter estimator. Thus, the device can provide information relating to the spatial profile of the power supply noise within the functional block.

In some embodiments, the reference clock signal is provided by the signal generator. Conversely, in some embodiments, the reference clock signal is provided by a signal generator external to the integrated circuit. By using an external signal generator it can be ensured that the signal is a highly accurate and stable clock signal to aid in generating an accurate measurement of the power supply noise.

In some embodiments, the measure of the relative jitter provided by the jitter estimator comprises a information relating to the temporal variation of the jitter. Thus patterns in the power supply noise can be identified and analysed.

In a second aspect, there is provided a method of providing a power supply noise measurement for an integrated circuit, the integrated circuit having a functional block, the method comprising: providing a signal generator for providing a clock signal to the functional block, providing an antenna comprising a transistor, and located proximate to the functional block, the antenna being configured to receive the clock signal from the signal generator, and determining a measure of the power supply noise by analysing the relative jitter between a signal output from the antenna and a reference clock signal, wherein the transistor of the antenna receives electrical power from the same power source that delivers power to the functional block.

A third aspect provides an integrated circuit comprising a power supply noise measurement device.

## BRIEF DESCRIPTION OF THE DRAWINGS

The present invention is illustrated by way of example, and not by way of limitation, in the figures of the accompanying drawings, in which like reference numerals refer to similar elements and in which:

- Figure 1 is a schematic view of an example of a system on a chip (SoC) composed of three functional blocks;

- Figure 2 is a schematic view of a PSN according to a first embodiment;
- Figure 3 illustrates details of an antenna of the embodiment of Figure 2;
- Figure 4 illustrates details of a buffer that forms a part of the antenna of Figure 3;
- Figure 5 illustrates a typical scenario of an implementation of an embodiment;
- Figure 6 illustrates a timing diagram for signals in the first embodiment;
- Figure 7 illustrates a second embodiment; and
- Figure 8 illustrates a method of determining PSN using a differential technique.

## DESCRIPTION OF PREFERRED EMBODIMENTS

Embodiments will be described below by way of example in the context of a System-on-Chip (SoC) architecture for mobile applications. However, the skilled reader will appreciate that the embodiments can equally be applied in other situations, including applications that employ an integrated circuit device, and any application in which the power supply noise in the circuit is at issue.

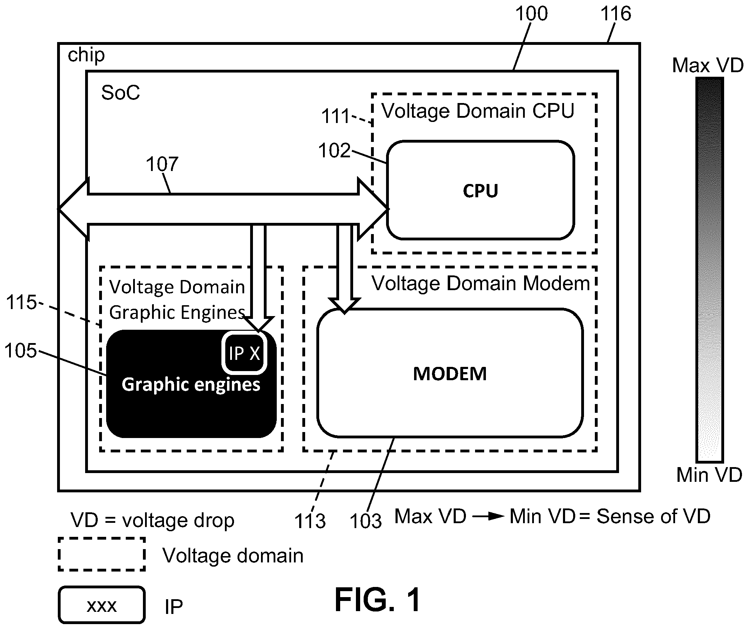

A typical SoC is composed of a plurality of functional blocks (IPs), each of which can be placed on different power/voltage domains. Figure 1 illustrates a schematic view of an example of a SoC, shown generally as 100, formed on an integrated circuit 116 and composed of three functional blocks. The skilled person will recognise that the embodiments can equally be applied to SoCs having a greater or lesser number of functional blocks.

In the example shown in Figure 1, these functional blocks are a Central Processing Unit (CPU) 102, a Graphical processing Unit (GPU) 105 and a MODEM 103. Each functional block 102, 103, 105 may have its own operating conditions, such as the particular power supply voltage (Vdd) and operating frequency (Freq). This is illustrated in Figure 1 by the different voltage domains in which the components are located. Thus, the CPU 102 is located in a first voltage domain 111, while the GPU 105 and MODEM 103 are similarly located in separate voltage domains 115 and 113 respectively. Each of the different voltage domains 111, 113, 115 can be supplied with different voltages and/or clock frequencies dependent on the current needs of the functional block or blocks within the domain. In addition, if a particular functional block is not required at a given time, then the voltage supplied to the respective domain can be switched to zero to thereby save power. In Figure 1, interconnections 107 are also shown between the CPU 102, GPU 105 and MODEM 103, these are for the transmission of data signals between the functional blocks.

The skilled person will recognise that the power consumed by a functional block can vary over time, dependent on the particular processing task or application that the functional block us undertaking. The power consumed is generally a function of the switching activity of the functional block. Thus, in general, if the switching activity of a functional block is high, then the power consumption will tend to be high. Similarly, low switching activity tends to result in a low power consumption for the functional block.

The skilled person will also recognise that the consumption of power by a functional block will result in a drop in the power supply voltage. To illustrate this, Figure 1 shows as an example that the MODEM 103 is currently in a situation of low switching activity, and therefore low voltage drop, as is indicated by the shading of the MODEM 103 with reference to the scale to the right of the Figure. In contrast, the CPU 102 is in a state of medium activity (medium voltage drop), while the GPU 105 is in a state of high activity (high voltage drop). Moreover, and as shown by the gradient in the shading illustrated on the CPU 102 and the MODEM 103, the activity level varies spatially within these functional blocks. This can be, for example, because the current activity of the functional block is higher for some particular area of circuitry. Thus, the voltage drop can vary both between functional blocks and also spatially within a functional block.

A reduction in the effective supply voltage to a functional block can lead to a reduction in the performance of the circuit in the functional block. This reduction in performance can, for example, manifest itself in the form of timing errors in signals within, or output from, the functional block. Thus, there is a direct relationship between noise in the power supply, for example caused by varying activity in a functional block varying the effective supply voltage, and timing errors observed in clock signals within the functional block.

Accordingly, in an embodiment, there is provided a sensor to detect the PSN within a functional block by detecting the presence of such timing errors.

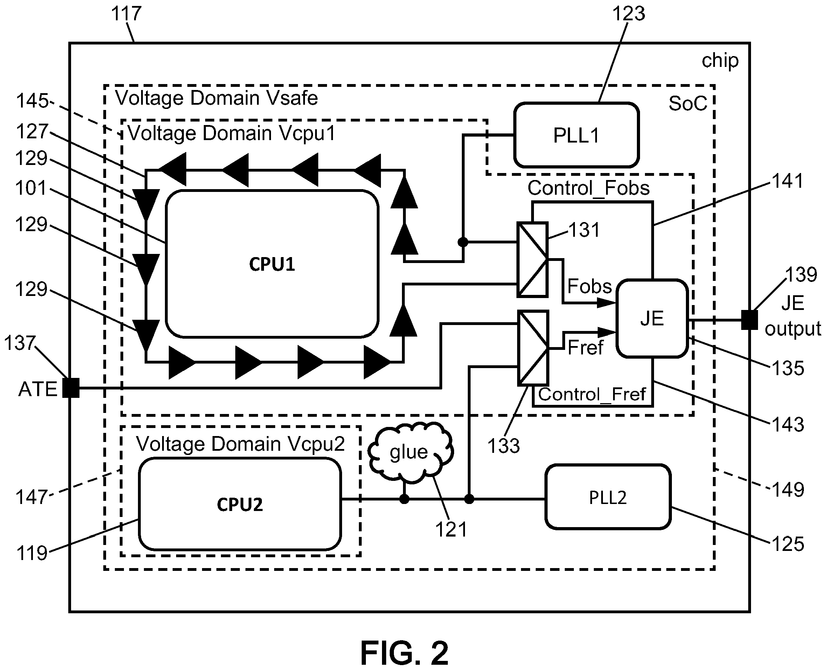

Figure 2 illustrates an embodiment in which a sensor is configured to detect the PSN experienced in a functional block, which is illustrated by way of example as a first CPU 101. The first CPU 101 is located on an integrated circuit shown generally as 117. Figure 2 illustrates the presence of a further functional block, in the form of a second CPU 119, on the integrated circuit 117, although as mentioned above the embodiment is applicable to an integrated circuit with any number of functional blocks. This fact is illustrated by the presence of the 'glue' 121, which indicates the presence of an arbitrary number of additional functional blocks and/or control circuitry.

The integrated circuit 117 also has a first phase-locked loop (PLL) 123. This generates a clock signal for the first CPU 101 using a crystal oscillator. The generation of such clock signals is well known in the art, and so a further explanation will not be included here. The output from the first PLL 123 is electrically connected to the first CPU 101 such that the clock pulses from the first PLL 123 can be used as a timing signal for the first CPU 101 in a usual, known, manner.

In a similar fashion, the integrated circuit 117 also has a second PLL 125, which is electrically connected to the second CPU 119 to supply clock pulses to the second CPU 119. The skilled person will recognise that by providing different PLLs 123, 125 for the different CPUs 101, 119, each CPU on the integrated circuit 117 can be operated independently. Thus, for example, the CPUs 101, 119 can be operated at different clock speeds, or one CPU can be deactivated when not in use to thereby save power. In the integrated circuit 117 illustrated, the glue 121 is also electrically connected to the second PLL 125. This is shown by way of example to indicate that not all of the processing functions on the integrated circuit 117 need be supplied clock signals via a dedicated PLL.

Surrounding the first CPU 101 is an antenna 127. The antenna 127 comprises a series of buffers 129 (for clarity not all of the buffers are labelled) connected in a daisy chain fashion. The antenna 127 is physically located as close as possible to the first CPU 101 so as to enable the most accurate sensing of the noise parameters. In the presently described embodiment, the buffers 129 that comprise the antenna are located outside of the first CPU 101. However, in alternative embodiments, the buffers 129 are included within the circuitry of the first CPU 101. Clearly, such an embodiment involves implementation of the described embodiment during the design phase of the first CPU 101. In contrast, implementation of the presently described embodiment can be achieved at the design phase of the integrated circuit 117, and so the design of the first CPU 101 need not be altered from a known design.

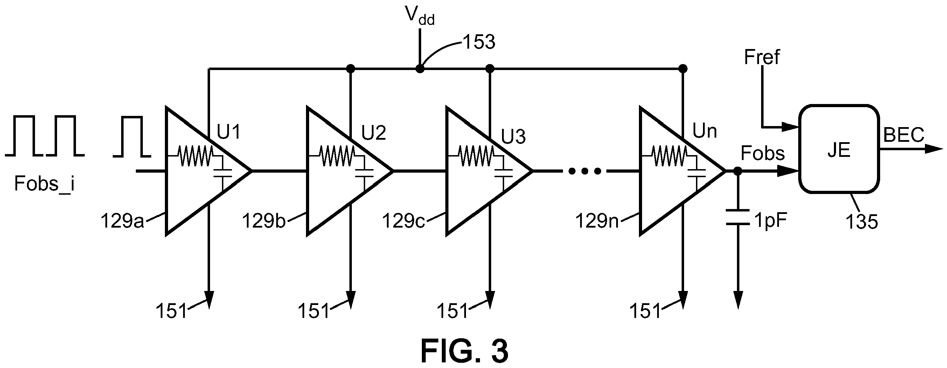

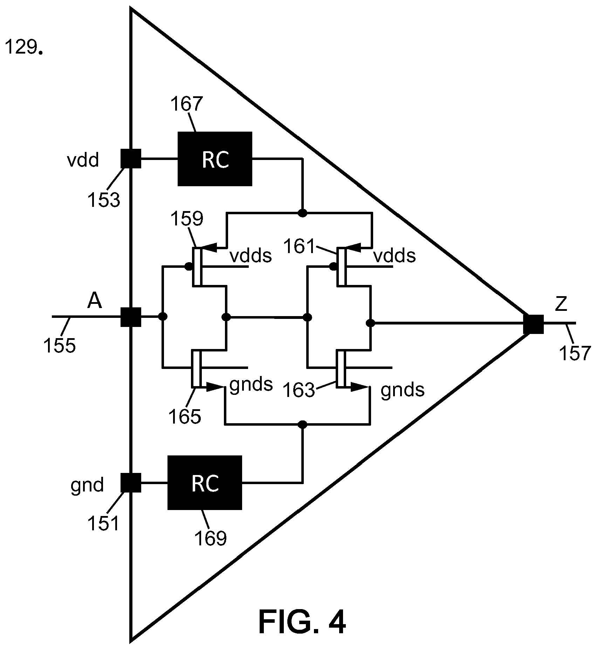

The structure of the antenna 127 and buffers 129 will be described in further detail below with reference to Figures 3 and 4. One end of the antenna 127 is electrically connected to the clock signal from the first PLL 123, while the other end of the antenna 127 is connected to an input of a first multiplexer 131. Thus, the clock signal from the first PLL 123 forms an input to the antenna 127 and, having passed through each buffer 129 that forms the antenna 127, the (potentially modified) clock signal is output to the first multiplexer 131. In addition, the clock signal from the first PLL 123 is connected to a second input of the first multiplexer 131.

The first multiplexer 131 is configured to selectably output either the clock signal from the first PLL 123, or the clock signal that has passed through the antenna 127. The output from the first multiplexer 131 is electrically connected to a first input of a jitter estimator (JE) 135. The JE will be described in greater detail with reference to Figure 4.

A second multiplexer 133 is also present on the integrated circuit 117, this has two inputs, a first input receives a clock signal from the second PLL 125, while the second input is electrically connected to an external contact pad 137 located at the edge of the integrated circuit 117. The contact pad 137 enables an external clock signal, for example from automated test equipment (ATE), to be input to the second multiplexer 133. The second multiplexer 133 is configured to selectable output either its first or second inputs to a second input of the JE 135.

The JE has an output that is electrically connected to an external contact pad 139 such that the output of the JE 125 can be received by external equipment. Additionally, the JE 125 has a first control output 141 provides a control signal to the first multiplexer 131 to enable selection of the desired signal to be output to the JE 135. Similarly, a second control output 143 of the JE 135 enables selection of the desired signal from the second multiplexer 133 to be output to the JE 135.

The integrated circuit 117 is divided into voltage domains, wherein all components within a given domain are supplied electrical power from the same source, and so operate at the same voltage. As a result, components with a voltage domain will also therefore tend to experience the same voltage fluctuations resulting from power supply noise. The skilled user will be familiar with the concept of voltage domains, and so a detailed explanation will not be provided here. In the integrated circuit 117, the first CPU 101, the antenna 127, the first and second multiplexers 131, 133 and the JE 135 are all located in a first voltage domain 145. The second CPU 119 is located in a separate voltage domain 147, while the glue 121, and first 123 and second 125 PLLs are all in a further voltage domain 149.

Figure 3 illustrates further details of the antenna 127. As noted above, the antenna 127 is comprised of a chain of substantially identical buffers 129 connected in a daisy chain fashion. Thus, the output of the first buffer in the chain 129a forms the input to the second buffer 129b, the output of which in turn forms the input to the third buffer 129c. The input to the first buffer 129a is provided by the clock signal from the first PLL 123, while the output to the last buffer in the chain 129n is used as an input to the first multiplexer 131. Power for each buffer 129a-n in the chain is supplied by connections between ground 151 and the voltage supply (Vdd) 153 in the voltage domain 145 that is local to the first CPU 101. Thus, each buffer 129a-n in the chain is powered by a voltage that is directly representative of the voltage supply that is local to the part of the first CPU 101 to which it is adjacent. Accordingly, each buffer 129a-n provides a means of detecting the supply voltage for the CPU 101 in its local area. Also shown in Figure 4 are the effective parasitic capacitance and resistance arising from each buffer 129, these will be described in greater detail with reference to Figure 4.

The skilled person will recognise that there is no particular limit on the number of buffers 129 that can be daisy-chained in this manner to form an antenna 127. Therefore, antennas of arbitrary length can be generated using such buffers 129.

Figure 4 illustrates further details of each buffer 129a-n, each of which is substantially identical. Each buffer comprises two pMOS transistors 159, 161 and two nMOS transistors 163, 165. The gate terminals of a first nMOS 165 and a first pMOS 159 are electrically connected to an input 155 to the buffer 129. The drain terminals of each of the first nMOS 165 and the first pMOS 159 are electrically connected to the gate terminals of the second nMOS 163 and the second pMOS 161, which are electrically connected together.

The source terminals of the first 159 and second 161 pMOS are connected to the supply voltage (Vdd) 153, while the drain terminals of the first 165 and second 163 nMOS are connected to ground 151. The output 157 to the buffer 129 is electrically connected to the drain terminals of both the second pMOS 161 and the second nMOS 163.

Also shown in Figure 4 are effective parasitic RC circuits that exist between the supply voltage 153 and the source terminals of the first 159 and second 161 pMOS, and also between the ground 151 and the drain terminals of the first 165 and second 163 nMOS.

The skilled person will recognise that the action of the circuit formed in the buffer 129 is to switch the output 157 high when the input 155 is switched high, and to switch the output 157 low when the input 155 is switched low. Thus, this is the usual action of a buffer circuit. The skilled person will also recognise that some delay will occur between the switching of the input 155 and the resulting switching of the output 157. This delay will depend on many factors, such as the particular transistors used and their configuration, the ambient temperature, and also the particular supply voltage to the transistors. Thus, under circumstances where all other parameters that affect the switching time of the buffer 129 are held approximately constant, the switching time of the buffer 129 can be used to sense the power supply voltage.

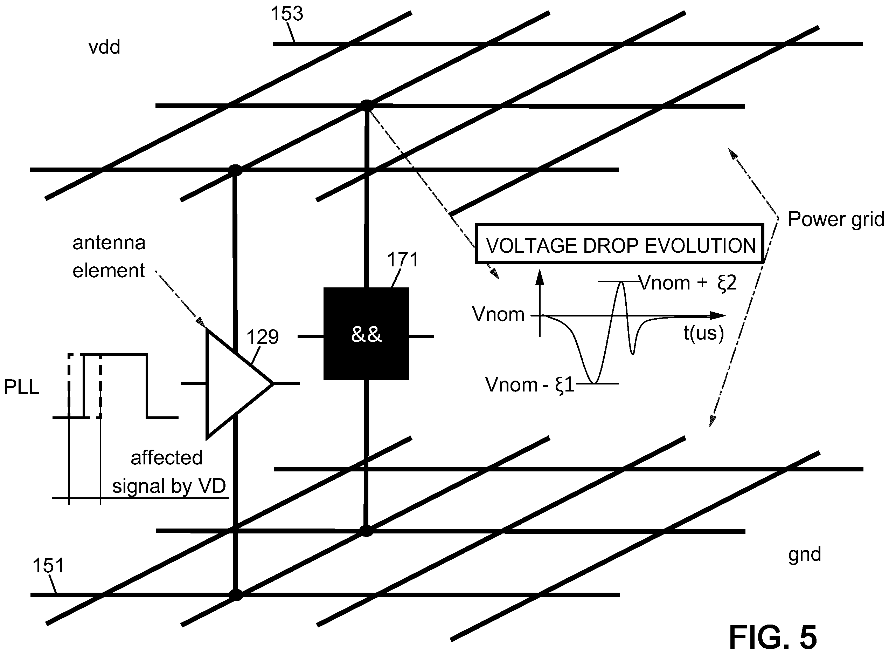

Figure 5 illustrates a typical scenario in which the described embodiment can be put to use. Typically, in an integrated circuit comprising many electronic components, the components will have electrical connections to convey signals between the various components, and also electrical connections to provide power to each component. As illustrated in Figure 5, an electrical component 171, such as a logic gate, has power supply connections to ground 151 and to a voltage supply 153. Since there are generally many electrical components 171 in an integrated circuit, the ground 151 and voltage supply 153 connections each take the form of a grid or mesh of electrical conductors. Each electrical component 171 is connected to nodes in the ground 151 mesh and the power supply 153 mesh. By providing electrical power to the buffers 129 that form the antenna 127 from nodes in the same mesh for the ground 151 and voltage supply 153, it can be ensured that the buffers 129 experience the same supply voltage, including any noise, as experienced by the electronic components 171 of the integrated circuit.

Figure 5 also illustrates a typically observed supply voltage fluctuation that can be caused by activity in the electronic component 171. As can be seen from the figure, when the electrical component is idle, i.e. not switching, the power supply voltage is at some nominal value, $V_{nom}$. When some activity occurs in the electronic component, the power supply voltage drops, in this case to $(V_{nom}-\xi_1)$ since power is consumed by the activity of the component 171. Once the activity ceases, the supply voltage will rise towards $V_{nom}$. However, there is typically some overshoot and, as illustrated the supply voltage then rises to $(V_{nom}+\xi_2)$, before again falling below $V_{nom}$ and then eventually settling back to $V_{nom}$.

If the switching of the buffer 129, caused by input of a clock pulse to the buffer 129, occurs during a period when the supply voltage is equal to $V_{nom}$, then the delay in the buffer switching will have some nominal value. However, if the switching of the buffer 129 occurs when the supply voltage is below $V_{nom}$, then the switching of the buffer 129 will be delayed by an increased amount compared to the nominal value. Conversely, if the switching of the buffer 129 occurs when the supply voltage is above $V_{nom}$, then the switching of the buffer 129 will be delayed by a reduced amount compared to the nominal value. Thus, a timing variation in the buffer switching, and thereby propagation of the clock signal through the antenna 127, will be observed.

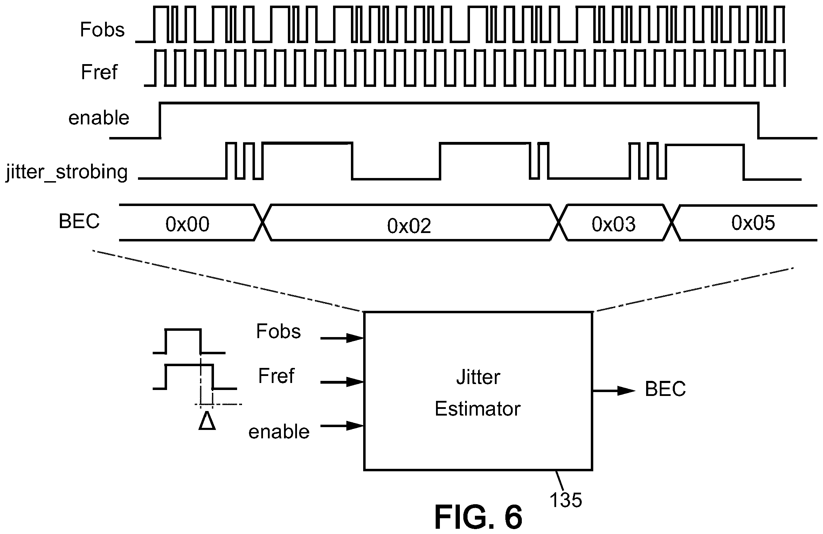

The function of the power supply noise sensor will now be described with reference to Figures 2-6. Figure 6 illustrates an example timing diagram for input and output signals to the JE 135 in the integrated circuit 117 illustrated in Figure 2. In the example timing diagram illustrated in Figure 6, it is assumed that the second multiplexer 133 is switched such that a clock signal from some external test equipment is provided to the second input of the JE 135. This trace is labelled $F_{ref}$ and, as can be seen from the figure, this corresponds to a normal square-pulse signal that would, for example, be used as a clock pulse for driving a processor, such as a CPU. Since the signal is provided by external test equipment, the period of the clock pulse is regular to a high degree of accuracy, thus each square pulse in the trace is substantially identical to each other pulse.

In the example illustrated in Figure 6, it is further assumed that the first multiplexer 131 is switched such that the signal from the antenna 127 is output to the JE 135 as $F_{obs}$. Thus, the trace illustrated as $F_{obs}$ represents a clock pulse that was generated by the first PLL 123 and which was then propagated through the antenna 127. As is clear from the illustration of $F_{obs}$, this trace is less regular than the $F_{ref}$ trace. Since the signal from the $F_{obs}$ trace has propagated around the antenna 127, this signal has accumulated timing errors as a result of the small fluctuations in the local value of Vdd. The JE 135 is configured to compare the $F_{obs}$ signal with that of $F_{ref}$ to determine the relative jitter that is present on the $F_{obs}$ signal.

Figure 6 also illustrates a schematic of the JE 135. In addition to the $F_{obs}$ and $F_{ref}$ inputs and the BEC output, the JE 135 also has an enable input. The enable input is used to enable the JE 135 for the purpose of performing noise measurements.

Typically, the clock frequency for a CPU can be of the order of 1GHz, thus the clock period will be of the order of 1ns. Jitter observed in $F_{obs}$ signal can typically be of the order of 50ps in a given clock period. Thus, in the presence of jitter, the clock period observed on $F_{obs}$ can typically be between 0.95ns and 1.05ns for each buffer 129 in the antenna 127.

Estimations of jitter based on a system employing undersampling are provided in each of Huang JJ., et al, "A Low-Cost Jitter Measurements Technique for BIST Applications", A TS 2003, pp. 336-339, and S. Sunter and A. Roy, "On-chip digital jitter measurement, from megahertz to gigahertz," IEEE Des. Test Comput., vol. 21, no. 4, pp. 314-321, Jul.-Aug. 2004.

A full description of the implementation of a jitter estimator is provided in *H. Le-Gall, "Estimating of the jitter of a clock signal."* U.S. Patent 7,487,055, issued Feb. 3, 2009. Accordingly, a full description will not be provided here. However, in brief, the JE 135 uses an edge (either the rising edge or the falling edge) of each pulse in the $F_{ref}$ signal to trigger measurement of the $F_{obs}$ signal for a brief period. Thus, the $F_{obs}$ signal is sampled (or 'strobed') for a short window at regular intervals determined by the frequency of the $F_{ref}$ signal.

From the traces of $F_{ref}$ and $F_{obs}$ illustrated in Figure 6, it can be seen that if there is no jitter present in the $F_{obs}$ signal, then sampling of the $F_{obs}$ signal at regular intervals will always result in the same result. In other words, in terms of the digital value, the sampled value will always be either high or low. However, if jitter is present in the $F_{obs}$ signal, then the regular sampling will sometimes result in a high output, and sometimes in a low output. This result is illustrated in the trace labelled 'jitter_strobing' in Figure 6. As is clear from the jitter_strobing trace, the value of the jitter_strobing signal changes each time the result of the sampling changes, thus there are sometimes relatively long periods, when the jitter is small, in which the jitter counter either remains high or remains low.

The output from the JE 135 is in the form of a bus of 17 bits called a Beat Edge Counter (BEC). The output from the BEC is illustrated in the lowest trace in Figure 6. As can be seen from the figure, the value of BEC corresponds to the number of timing uncertainties (jitter) between $F_{obs}$ and $F_{ref}$. Thus, each complete cycle in the jitter counter (rising edge to rising edge) results in the BEC being incremented by one. In other words, if there is exactly one rising edge and one falling edge on the $F_{obs}$ trace per cycle of the $F_{ref}$ trace, then there will be no increment of the BEC trace, otherwise, the BEC will be incremented.

To form the output of the BEC, $F_{obs}$ is sampled using $F_{ref}$ for a given time period, and is output, for example to a shift register, by the JE 135 in the form of a 17 bit binary word. This word can be used to estimate the magnitude of the PSN, and also to identify patterns in the PSN.. Moreover, the values of the BEC can be correlated with activity in the CPU 101.

To use the output from the JE 135 to provide useful information, it may be necessary to calibrate the output. In this regard, the most important characteristic of the antenna 127 is its gain, since this describes how sensitive the antenna 127 is to variations in the system power consumption. The Antenna Gain (AG) can be defined as:

$$AG = |BEC_{actual} - BEC_{ref}| / BEC_{antenna\_char} \qquad (1)$$

where:

BEC$_{actual}$ is the JE 135 output measured from the antenna 127 whilst the first CPU 101 is running a given application;
BEC$_{ref}$ is the JE 135 output measured from the antenna 127 during a calibration process, the details of which are described below; and,
BEC$_{antenna\_char}$ is the JE 135 output that results from propagation through the antenna, in other words in the absence of the first CPU 101. This can also be considered as the noise introduced by the antenna. Alternatively, BEC$_{antenna\_char}$ could also determined whilst the first CPU 101 is running no application.

In order to determine the value of BEC$_{antenna\_char}$, a simulation of the antenna 127 can be generated, for example using a simulation program such as SPICE. Within the simulation, the clock frequency ($F_{obs\_i}$) is set to be the same as the frequency used during stimuli application. The measured BEC$_{antenna\_char}$ contains the skew and the jitter of the clock signal propagated through the antenna with respect to the $F_{ref}$ signal, and this variation represents the internal error of antenna.

To determine the gain of the antenna, the values of BEC$_{ref}$ and BEC$_{actual}$ also have to be computed using the value of BEC$_{antenna\_char}$ calculated from the simulation. The BEC$_{ref}$ value can for example be computed by using IDLe pattern generator (IDLG) patterns over different power supply conditions {Vmin, Vnom, Vmax}. For the computation of BEC$_{actual}$, high stress stimuli generated by an automatic test pattern generator (ATPG) or another high stress stimuli typically generated by functional pattern generator can be used. The higher the BEC value, the higher the precision of the sensor. The same observation can be made for the AG. It other words, higher AG values lead to better accuracy and efficiency of the sensor.

In other words, $V_{drop}$ can be calculated by determining the BEC at two or more values {Vmin, Vnom, Vmax} of the supply voltage with no activity in the CPU 101. From this, the function of BEC verses BEC can be determined. Thus, a value of $V_{drop}$ when there is activity in the CPU 101 can be assumed from the measured value of BEC.

Using the calibration of the antenna, an estimate of the PSN can be generated by analysing the jitter observed during, for example execution of a particular application by the first CPU 101.

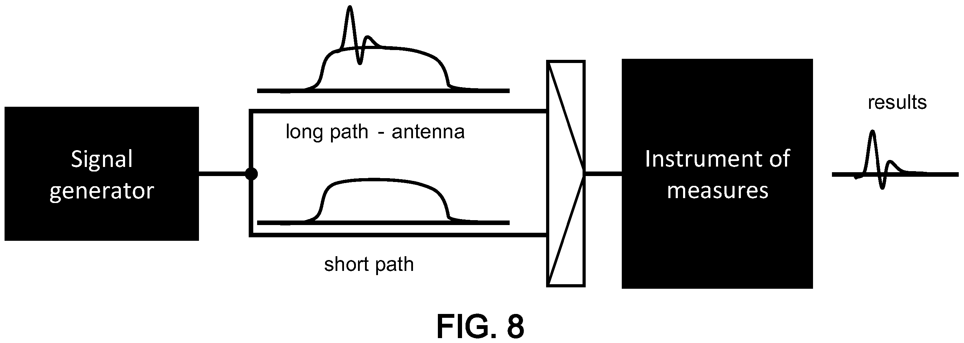

A differential measurement technique can be used to obtain a measure of the power supply noise. Figure 8 illustrates a process for implementing such a differential technique. In a first instance, the first multiplexer 131 is configured to route the clock signal from the first PLL 123 to the JE 135. This is known as the 'short path', since the clock signal arrived at the JE 135 directly from the first PLL 135. Subsequently, a measure of the jitter, and thereby the PSN, is made using the clock signal from the first PLL 123 relative to a further clock signal. The further clock signal can either be from a second PLL 125 on the integrated circuit 117, or from external equipment, such as an ATE.

Then, the first multiplexer 131 is switched to route the clock signal from the antenna 127 to the JE 135. This is known as the long path' since the clock signal was generated by the first PLL 123 and arrived at the JE 135 via the antenna 127. Subsequently, a measure of the jitter, and thereby the PSN, is made using the clock signal from the antenna 127 relative to the same further clock signal as in the previous measurement step.

Finally, the result of the first measurement is subtracted from the result of the second measurement to yield an estimate of the PSN noise that is experienced by the antenna, and therefore by the first CPU 101.

Since the measurements will be carried out at different times, this method relies on the jitter from the first PLL 123 being constant over the timescale of the two measurements.

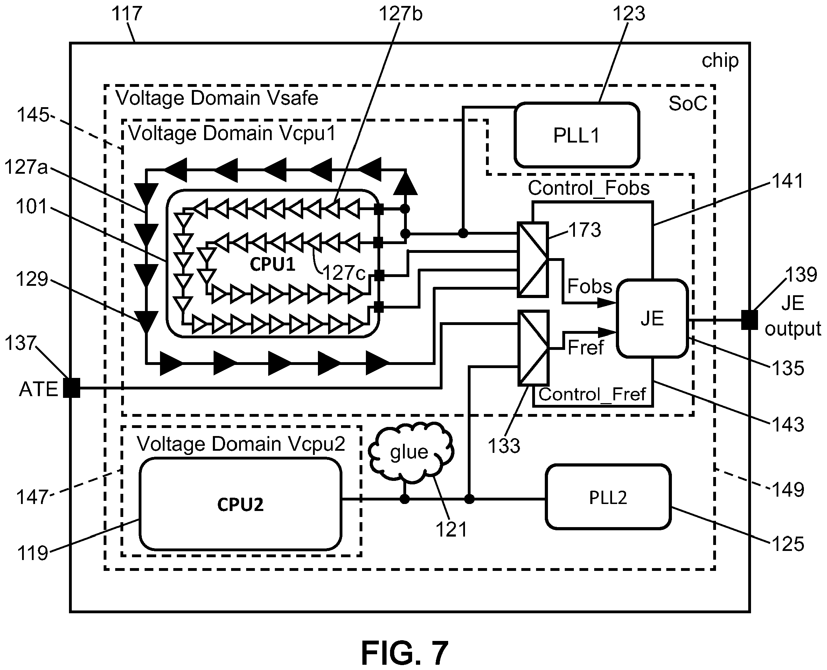

In an alternative embodiment more than one antenna 127 can be employed for a given functional block. Figure 7 illustrates an example of such an embodiment and, as can be seen from the figure, the embodiment is essentially similar to the above described embodiment. Accordingly, the features that are shared between the two embodiments will not be described again here. In the example illustrated in Figure 7, three antennas 127a-c are illustrated. The first antenna 127a is substantially identical to the antenna 127 as previously described. The second antenna 127b is located within the first CPU 101, and can therefore detect PSN from a different location to the first antenna 127a. Moreover, a comparison of the PSN detected by the first antenna 127a with that detected by the second antenna 127b can yield some information about the spatial profile of the PSN. A third antenna 127c is also located within the first CPU 101, and inside of the second antenna 127b. Comparison of the PSN detected by this antenna 127c with the other antenna 127a, 127b can yield a more detailed spatial profile of the PSN.

To accommodate the presence of more than one antenna, a multiplexer 173 with four inputs is used. This multiplexer 173 accepts inputs from each of the antennas 127a-c and also the clock signal from the first PLL 123. The multiplexer 173 is configured to selectably output either the clock signal from the first PLL 123 or the clock signal that has passed through any one of the antennas 127a-c. Thus, the multiplexer allows the PSN detected by each of the antennas 127a-c to be detected. By making repeated measurements with each antenna 127a-c in turn, a complete set of results can be obtained. The skilled person will recognise that the number of antennas 127 is essentially unlimited, and so embodiments with any number of antennas 127 are also possible. Moreover, any mixture of antennas 127 that are located within a functional block, or surrounding the functional block can equally be used.

In further embodiments, antennas of differing shapes can be used. Thus, the antenna shape can be altered to fit with a particular construction of interest on a functional block.

In further embodiments, antennas can be placed in or around more than one functional block within an integrated circuit. In such embodiments, it is possible to share components such as the signal generator and/or jitter estimator between the different functional blocks.

Expressions such as "comprise", "include", "incorporate", "contain", "is" and "have" are to be construed in a non-exclusive manner when interpreting the description and its associated claims, namely construed to allow for other items or components which are not explicitly defined also to be present. Reference to the singular is also to be construed in be a reference to the plural and vice versa.

While there has been illustrated and described what are presently considered to be the preferred embodiments of the present invention, it will be understood by those skilled in the art that various other modifications may be made, and equivalents may be substituted.

A person skilled in the art will readily appreciate that various parameters disclosed in the description may be modified and that various embodiments disclosed and/or claimed may be combined.

**Claims**

**1.** An integrated circuit comprising a power supply noise measurement device, the integrated circuit (117) having a functional block (101), the noise measurement device comprising:

a signal generator (123) configured to provide a clock signal to the functional block (101),

an antenna (127) comprising a transistor, and being located proximate to the functional block (101), the antenna (127) being configured to receive the clock signal from the signal generator (123), and

a jitter estimator (135) configured to provide a measure of the relative jitter between a signal output from the antenna (127) and a reference clock signal, and

the transistor of the antenna (127) receives electrical power from the same power source that delivers power to the functional block (101).

2. The integrated circuit according to claim 1, wherein the antenna (127) comprises a buffer (129), the buffer (129) comprising a plurality of transistors configured to relay the clock signal from an input of the buffer (129) to an output of the buffer (129).

3. The integrated circuit according to claim 2, wherein the antenna (127) comprises a plurality of buffers (129) electrically connected in a daisy-chain fashion, whereby the output of buffers (129) in the daisy-chain are connected to the input of the subsequent buffer (129) in the daisy-chain.

4. The integrated circuit according to any preceding claim, wherein the power to the, or each, transistor in the antenna (127) is taken from a mesh of electrical contacts that also provides electrical power to components within the functional block (101).

5. The integrated circuit according to any preceding claim, wherein the functional block (101), antenna (127) and jitter estimator (135) are all located within a voltage domain (145), and wherein a common power source supplies power to the voltage domain.

6. The integrated circuit according to any preceding claim, wherein the antenna (127) is formed as a part of the functional block (101).

7. The integrated circuit according to any preceding claim, further comprising a multiplexer (131), wherein the multiplexer is configured to selectably transfer either the clock signal from the signal generator (123), or the signal output from the antenna (127), to the jitter estimator (135).

8. The integrated circuit according to any preceding claim, wherein a plurality of antennas (127) are provided in or proximate to the functional block (101), each of the antennas (127) being configured to receive the clock signal from the signal generator (123), and each being configured to provide an input to the jitter estimator (135).

9. The integrated circuit according to any preceding claim, wherein the reference clock signal is provided by the signal generator (123).

10. The integrated circuit according to any of claims 1 to 8, wherein the reference clock signal is provided by a signal generator external to the integrated circuit (117).

11. The integrated circuit according to any of claims 1 to 8, further comprising a second multiplexer (133) configured to selectable provide the reference clock signal either from a signal generator (125) located on the integrated circuit (117), or from a signal generator external to the integrated circuit.

12. The integrated circuit according to any preceding claim, wherein the measure of the relative jitter provided by the jitter estimator (135) comprises a information relating to the temporal variation of the jitter.

13. A method of providing a power supply noise measurement included in an integrated circuit (117), the integrated circuit (117) having a functional block (101), the method comprising:

providing a signal generator (123) for providing a clock signal to the functional block (101),

providing an antenna (127) comprising a transistor, and located proximate to the functional block (101), the antenna (127) being configured to receive the clock signal from the signal generator (123), and

determining a measure of the power supply noise by analysing the relative jitter between a signal output from the antenna (127) and a reference clock signal,

and the transistor of the antenna (127) receives electrical power from the same power source that delivers power to the functional block.

**Patentansprüche**

1. Integrierte Schaltung, umfassend eine Stromversorgungs-Rauschmessungsvorrichtung, wobei die integrierte Schaltung (117) einen Funktionsblock (101) aufweist, wobei die Rauschmessungsvorrichtung umfasst:

   einen Signalgenerator (123), der dazu ausgelegt ist, ein Taktsignal für den Funktionsblock (101) bereitzustellen, eine Antenne (127), die einen Transistor umfasst und sich in der Nähe des Funktionsblocks (101) befindet, wobei die Antenne (147) dazu ausgelegt ist, das Taktsignal von dem Signalgenerator (123) zu empfangen, und eine Jitter-Schätzeinrichtung (135), die dazu ausgelegt ist, eine Messung des relativen Jitters zwischen einer Signalausgabe von der Antenne (127) und einem Referenztaktsignal bereitzustellen, und wobei der Transistor der Antenne (147) elektrischen Strom von derselben Stromquelle empfängt, die Strom für den Funktionsblock (101) liefert.

2. Integrierte Schaltung nach Anspruch 1, wobei die Antenne (127) einen Puffer (129) umfasst, der Puffer (129) eine Vielzahl von Transistoren umfasst, die dazu ausgelegt sind, das Taktsignal von einem Eingang des Puffers (129) zu einem Ausgang des Puffers (129) weiterzuleiten.

3. Integrierte Schaltung nach Anspruch 2, wobei die Antenne (127) eine Vielzahl von Puffern (129) umfasst, die elektrisch in einer Daisy-Chain-Verkettung verbunden sind, wodurch der Ausgang der Puffer (129) in der Daisy-Chain mit dem Eingang des nachfolgenden Puffers (129) in der Daisy-Chain verbunden ist.

4. Integrierte Schaltung nach einem vorhergehenden Anspruch, wobei der Strom für den oder jeden Transistor in der Antenne (127) aus einem Netz von elektrischen Kontakten genommen wird, das außerdem elektrischen Strom für Komponenten innerhalb des Funktionsblocks (101) bereitstellt.

5. Integrierte Schaltung nach einem vorhergehenden Anspruch, wobei sich der Funktionsblock (101), die Antenne (127) und die Jitter-Schätzeinrichtung (135) alle innerhalb einer Spannungsdomäne (145) befinden, und wobei eine gemeinsame Stromquelle Strom für die Spannungsdomäne liefert.

6. Integrierte Schaltung nach einem vorhergehenden Anspruch, wobei die Antenne (127) als Teil des Funktionsblocks (101) ausgebildet ist.

7. Integrierte Schaltung nach einem vorhergehenden Anspruch, des Weiteren umfassend einen Multiplexer (131), wobei der Multiplexer dazu ausgelegt ist, wählbar entweder das Taktsignal von dem Signalgenerator (123) oder die Signalausgabe von der Antenne (127) an die Jitter-Schätzeinrichtung (135) auszugeben.

8. Integrierte Schaltung nach einem vorhergehenden Anspruch, wobei eine Vielzahl von Antennen (127) in oder nahe an dem Funktionsblock (101) bereitgestellt ist, wobei jede der Antennen (127) dazu ausgelegt ist, das Taktsignal von dem Signalgenerator (123) zu empfangen, und jede dazu ausgelegt ist, eine Eingabe für die Jitter-Schätzeinrichtung (135) bereitzustellen.

9. Integrierte Schaltung nach einem vorhergehenden Anspruch, wobei das Referenztaktsignal von dem Signalgenerator (123) bereitgestellt wird.

10. Integrierte Schaltung nach einem der Ansprüche 1 bis 8, wobei das Referenztaktsignal von einem Signalgenerator außerhalb der integrierten Schaltung (117) bereitgestellt wird.

11. Integrierte Schaltung nach einem der Ansprüche 1 bis 8, des Weiteren umfassend einen zweiten Multiplexer (133), der dazu ausgelegt ist, wählbar das Referenztaktsignal entweder von einem Signalgenerator (125), der sich in der integrierten Schaltung (117) befindet, oder von einem Signalgenerator außerhalb der integrierten Schaltung bereitzustellen.

12. Integrierte Schaltung nach einem vorhergehenden Anspruch, wobei die Messung des relativen Jitters, die von der Jitter-Schätzeinrichtung (135) bereitgestellt wird, eine Information bezüglich der zeitlichen Schwankung des Jitters umfasst.

13. Verfahren zum Bereitstellen einer Stromversorgungs-Rauschmessung, die in einer integrierten Schaltung (117) enthalten ist, wobei die integrierte Schaltung (117) einen Funktionsblock (101) aufweist, wobei das Verfahren umfasst:

Bereitstellen eines Signalgenerators (123) zum Bereitstellen eines Taktsignals für den Funktionsblock (101),
Bereitstellen einer Antenne (127), die einen Transistor umfasst und sich in der Nähe des Funktionsblocks (101) befindet, wobei die Antenne (127) dazu ausgelegt ist, das Taktsignal von dem Signalgenerator (123) zu empfangen, und
Bestimmen einer Messung des Stromversorgungsrauschens durch Analysieren des relativen Jitters zwischen einer Signalausgabe von der Antenne (127) und einem Referenztaktsignal,
und wobei der Transistor der Antenne (127) elektrischen Strom von derselben Stromquelle empfängt, die Strom für den Funktionsblock liefert.

**Revendications**

1. Circuit intégré comprenant un dispositif de mesure de bruit d'une alimentation électrique, le circuit intégré (117) ayant un bloc fonctionnel (101), le dispositif de mesure de bruit comprenant:

   un générateur de signal (123) configuré pour fournir un signal d'horloge au bloc fonctionnel (101),
   une antenne (127) comprenant un transistor et étant située à proximité du bloc fonctionnel (101), l'antenne (127) étant configurée pour recevoir le signal d'horloge en provenance du générateur de signal (123), et
   un estimateur de sautillement (135) configuré pour fournir une mesure du sautillement relatif entre un signal émis par l'antenne (127) et un signal d'horloge de référence, et
   le transistor de l'antenne (127) reçoit de l'énergie électrique de la même source d'alimentation que celle qui alimente le bloc fonctionnel (101).

2. Circuit intégré selon la revendication 1, dans lequel l'antenne (127) comprend un tampon (129), le tampon (129) comprenant une pluralité de transistors configurés pour relayer le signal d'horloge provenant d'une entrée du tampon (129) vers une sortie du tampon (129).

3. Circuit intégré selon la revendication 2, dans lequel l'antenne (127) comprend une pluralité de tampons (129) connectés électriquement en guirlande, de sorte que la sortie des tampons (129) dans la guirlande est connectée à l'entrée du tampon suivant (129) dans la guirlande.

4. Circuit intégré selon l'une quelconque des revendications précédentes, dans lequel l'alimentation du ou de chaque transistor de l'antenne (127) provient d'un maillage de contacts électriques qui fournit une alimentation électrique aux composants dans le bloc fonctionnel (101).

5. Circuit intégré selon l'une quelconque des revendications précédentes, dans lequel le bloc fonctionnel (101), l'antenne (127) et l'estimateur de sautillement (135) sont tous situés dans un domaine de tension (145), et dans lequel une source d'alimentation commune alimente le domaine de tension.

6. Circuit intégré selon l'une quelconque des revendications précédentes, dans lequel l'antenne (127) fait partie du bloc fonctionnel (101).

7. Circuit intégré selon l'une quelconque des revendications précédentes, comprenant en outre un multiplexeur (131), dans lequel le multiplexeur est configuré pour transférer de manière sélective soit le signal d'horloge en provenance du générateur de signal (123) ou du signal émis par l'antenne (127) vers l'estimateur de sautillement (135).

8. Circuit intégré selon l'une quelconque des revendications précédentes, dans lequel une pluralité d'antennes (127) sont prévus dans ou à proximité du bloc fonctionnel (101), chacune des antennes (127) étant configurée pour recevoir le signal d'horloge en provenance du générateur de signal (123), et chacune étant configurée pour fournir une entrée à l'estimateur de sautillement (135).

9. Circuit intégré selon l'une quelconque des revendications précédentes, dans lequel le signal d'horloge de référence est fourni par le générateur de signal (123).

10. Circuit intégré selon l'une quelconque des revendications 1 à 8, dans lequel le signal d'horloge de référence est fourni par un générateur de signal externe au circuit intégré (117).

**11.** Circuit intégré selon l'une quelconque des revendications 1 à 8, comprenant en outre un second multiplexeur (133) configuré pour fournir au signal d'horloge de référence pouvant être sélectionné, le signal d'horloge de référence, soit en provenance d'un générateur de signal (125) situé sur le circuit intégré (117), soit en provenance d'un signal générateur externe au circuit intégré.

**12.** Circuit intégré selon l'une quelconque des revendications précédentes, dans lequel la mesure du sautillement relatif fourni par l'estimateur de sautillement (135) comprend une information relative à la variation temporelle du sautillement.

**13.** Procédé permettant de fournir une mesure de bruit d'alimentation contenue dans un circuit intégré (117), le circuit intégré (117) comportant un bloc fonctionnel (101), le procédé comprenant les étapes suivantes:

fournir un générateur de signal (123) permettant de fournir un signal d'horloge au bloc fonctionnel (101),
fournir une antenne (127) comprenant un transistor et étant située à proximité du bloc fonctionnel (101), l'antenne (127) étant configurée pour recevoir le signal d'horloge en provenance du générateur de signal (123), et
déterminer une mesure du bruit d'alimentation en analysant le sautillement relatif entre un signal émis par l'antenne (127) et un signal d'horloge de référence,
et le transistor de l'antenne (127) reçoit de l'énergie électrique de la même source d'alimentation qui alimente le bloc fonctionnel.

FIG. 1

Max VD

Min VD

Max VD → Min VD = Sense of VD

VD = voltage drop

Voltage domain

IP

xxx

chip

SoC

100

116

Voltage Domain CPU

111

CPU

102

107

Voltage Domain Modem

MODEM

103

113

Voltage Domain Graphic Engines

Graphic engines

IP X

115

105

FIG. 2

FIG. 3

**FIG. 4**

FIG. 5

FIG. 6

FIG. 7

FIG. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7487055 B

**Non-patent literature cited in the description**

- **T SAXENA, K. et al.** A Case Study of IR-Drop in Structured At-Speed Testing. *IEEE Int'l Test Conf.,* 2003, 1098-1104
- **K. ARABI et al.** Power Supply Noise in SoCs: Metrics, Management, and Measurement. *IEEE Design & Test of Computers,* May 2007, vol. 24 (3
- **CHAKRAVARTY S. et al.** Optimal Manufacturing Flow to Determine Minimum Operating Voltage. *ITC,* 2011, 1-10
- **FRANCH R. et al.** On-chip Timing Uncertainty Measurements on IBM Microprocessors. *ITC,* 2007, 1-7
- **HUANG JJ. et al.** A Low-Cost Jitter Measurements Technique for BIST Applications. *ATS,* 2003, 336-339
- **S. SUNTER et al.** On-chip digital jitter measurement, from megahertz to gighertz. *IEEE Design & Test of Computers,* 01 July 2004, vol. 21 (4), ISSN 0740-7475, 314-321
- **HUANG JJ. et al.** A Low-Cost Jitter Measurements Technique for BIST Applications. *A TS,* 2003, 336-339
- **S. SUNTER ; A. ROY.** On-chip digital jitter measurement, from megahertz to gigahertz. *IEEE Des. Test Comput.,* July 2004, vol. 21 (4), 314-321